(19)

Europäisches
Patentamt
European
Patent Office
Office européen
des brevets

(11) **EP 2 157 701 B1**

(12) **EUROPEAN PATENT SPECIFICATION**

(45) Date of publication and mention
of the grant of the patent:
**11.01.2017 Bulletin 2017/02**

(51) Int Cl.:
*H03M 13/00* (2006.01)   *H04L 1/00* (2006.01)

(21) Application number: **09015257.0**

(22) Date of filing: **04.06.2001**

(54) **Method and apparatus for puncturing code symbols in a communication system**

Verfahren und Vorrichtung zum Punktieren von Codesymbolen in einem Kommunikationssystem

Procédé et appareil de perforation de symboles de codes dans un système de communications

(84) Designated Contracting States:
**AT BE CH CY DE DK ES FI FR GB GR IE IT LI LU MC NL PT SE TR**

(30) Priority: **02.06.2000   US 587168**
**07.07.2000   US 612158**

(43) Date of publication of application:
**24.02.2010   Bulletin 2010/08**

(62) Document number(s) of the earlier application(s) in
accordance with Art. 76 EPC:
**01981927.5 / 1 301 995**

(73) Proprietor: **Qualcomm Incorporated**
**San Diego, CA 92121-1714 (US)**

(72) Inventors:
• **Razoumov, Leonid**
**San Diego, CA 92103 (US)**

• **Ling, Funyun**
**San Diego, CA 92121-1714 (US)**

(74) Representative: **Carstens, Dirk Wilhelm**
**Wagner & Geyer**
**Gewürzmühlstraße 5**
**80538 München (DE)**

(56) References cited:
**WO-A1-00/21234     WO-A2-01/47124**

• **UMTS: "UTRAN, UTRA FDD, multiplexing, channel coding and interleaving description (UMTS xx.04 version 1.0.0)", UMTS XX.04 V1.0.0, XX, XX, 1 February 1999 (1999-02-01), pages 1-16, XP002181831,**

**Description**

**BACKGROUND OF THE INVENTION**

**I. Field of the Invention**

The present invention relates to data communications. More particularly, the present invention relates to a method and apparatus for puncturing code symbols to provide improved performance in a communications system.

**II. Description of the Related Art**

In a typical digital communications system, data is processed, modulated, and conditioned at a transmitter unit to generate a modulated signal that is then transmitted to one or more receiver units. The data processing may include, for example, formatting the data into a particular frame format, encoding the formatted data with a particular coding scheme to provide error detection and/or correction at the receiver unit, puncturing (i.e., deleting) some of the code symbols to fit within a particular frame size, channelizing (i.e., covering) the encoded data, and spreading the channelized data over the system bandwidth. The data processing is typically defined by the system or standard being implemented.

At the receiver unit, the transmitted signal is received, conditioned, demodulated, and digitally processed to recover the transmitted data. The processing at the receiver unit is complementary to that performed at the transmitter unit and may include, for example, despreading the received samples, decovering the despread samples, inserting "erasures" in place of punctured symbols, and decoding the symbols to recover the transmitted data.

A digital communications system typically employs a convolutional code or a Turbo code to provide error correction capability at the receiver unit. The ability to correct transmission errors enhances the reliability of a data transmission. Conventionally, convolutional and Turbo coding is performed using a particular polynomial generator matrix that generates a particular number of code symbols (e.g., 2, 3, or more code symbols) for each input data bit. For example, a rate 1/2 encoder generates two code symbols for each data bit.

A multiple access communications system typically transmits data in frames or packets of predetermined sizes to allow for efficient sharing of system resources among active users. For example, some communications systems support frame sizes that are multiple times a basic frame size (e.g., $768 \bullet K$ bits, where $K = 1, 2, ...$). For efficiency, some communications systems also support multiple data rates. Depending on a number of factors, a variable number of data bits (i.e., X) may be provided to the encoder, which then generates a corresponding number of code symbols (e.g., 2X).

In certain instances, the number of code symbols generated is not exactly equal to the capacity of the frame Symbol repetition and puncturing are then used to fit the generated code symbols into a frame of a particular size. For example, if the number of code symbols is less than the frame capacity, some or all of the code symbols may be repeated (i.e., duplicated) a particular number of times. Conversely or additionally after the symbol repetition, if the number of code symbols is greater than the frame capacity, some of the code symbols may be deleted (i.e., punctured).

The document WO 00/212234 relates to a data communications apparatus which operates to communicate data frames, said apparatus comprising means for converting the data frames into blocks for transmission, which data blocks are of a size which is different to that of the data frames. The means for converting the data frames includes means for puncturing or repeating bits or symbols at positions within the data frame determined in accordance with a selection strategy, wherein the selection strategy is arranged to provide an equal distribution of the positions throughout the data frame. The selection strategy is effected with a digital differential analyser type algorithm. In particular, WO 00/212234 shows a solution to the above state problem by providing an algorithm for puncturing symbols at positions within a data frame with an almost equal distribution.

**SUMMARY OF THE INVENTION**

An embodiment of the invention provides a method for puncturing symbols in a communications system (e.g., a system that conforms to CDMA-2000, W-CDMA, or 1XTREME standard, which are identified below). In accordance with the method, $S$ symbols are received for a frame having a capacity of N symbols, with S being greater than $N$. $P$ symbols need to be punctured from the $S$ received symbols such that the remaining unpunctured symbols fit into the frame. A number of puncture distances, $D1$ through $DN$, are then computed based on the $S$ received symbols and the $P$ symbol punctures. Next, a particular number of symbol punctures is determined for each computed puncture distance. $P1$ through $PN$ symbol punctures are then performed at the puncture distances of $D1$ through $DN$, respectively. For a more even distribution of the symbol punctures, each of the distances $D1$ through $DN$ can be selected to be greater than or equal to a minimum puncture distance $Dmin$ defined as:

$$D\min = \left\lfloor \frac{S}{P} \right\rfloor,$$

where $\lfloor \; \rfloor$ denotes a floor operator.

In a simple implementation, two puncture distances, *D1* and *D2,* can be computed based on S and P as follows:

$$D1 = \left\lfloor \frac{S}{P} \right\rfloor,$$

and

$$D2 = \begin{cases} D1 & if \; D1*P = S \\ D1+1 & otherwise. \end{cases}$$

*P1* and *P2* can then be computed as:

$$P2 = S - P*D1,$$

and

$$P1 = P - P2.$$

The symbol puncturing can be achieved by (1) selecting either the puncture distance of *D1* or *D2* to be used to determine which symbol should be punctured next, (2) puncturing the next symbol based on the selected puncture distance, and (3) decrementing *P1* or *P2* based on the selected puncture distance. Steps (1) through (3) can be repeated until all *P1* and *P2* symbol punctures are achieved. The puncture distance can be selected such that the *P1* symbol punctures at the distance of *D1* are distributed among the *P2* symbol punctures at the distance of *D2*. For example, if the ratio of *P1* to *P2* is equal to R, then the puncture distance can be selected such that, on an average, *R* symbol punctures are performed at the distance of *D1* for each symbol puncture at the distance of *D2*. Alternatively, *P1* symbol punctures at the distance of *D1* can be performed, followed by *P2* symbol punctures at the distance of *D2*. The method can thus be used to provide a rich set of patterns of puncture distances *D1* and *D2* that can provide improved performance.

The above concepts for two puncture distances can be applied to the general case in which *N* puncture distances are computed and used. The symbol punctures at each computed distance can be performed together or distributed with symbol punctures at other distances.

Prior to the symbol puncturing, the code symbols may have been repeated to generate the *S* received symbols. For example, in the CDMA-2000 system, each code symbol may be repeated *M* times, with *M* being an integer greater than or equal to one and selected such that *S* is greater than or equal to *N*. Also, the code symbols are typically generated by coding a number of data bits with a particular coding scheme (e.g., a convolutional or Turbo code).

Another embodiment of the invention provides a method for decoding symbols in a communications system. In accordance with the method, N symbols are initially received. It is then determined that *P* symbol punctures had been performed on *S* symbols to generate the *N* received symbols. A number of puncture distances, *D1* through *DN*, is then computed based on S and *P*, and *P1* through *PN* symbol punctures at the distances of *D1* through *DN,* respectively, are also determined. A puncturing pattern used to puncture the *S* symbols to generate the *N* received symbols is then derived based on the *P1* through *PN* symbol punctures at the distances of *D1* through *DN*, respectively. *P* erasures are then inserted among the *N* received symbols based on the derived puncturing pattern to generate *S* recovered symbols, which are then decoded with a particular decoding scheme. Again, for a more even distribution of the erasures/symbol punctures, each of the distances *D1* through *DN* can be selected to be greater than or equal to a minimum puncture distance *Dmin* defined above.

Yet another embodiment of the invention provides a transmit data processor for use in a communications system. The transmit data processor includes an encoder coupled to a symbol puncturing element. The encoder receives and codes data bits to generate code symbols. The symbol puncturing element (1) receives $S$ symbols for a frame having a capacity of $N$ symbols, with S being greater than $N$, (2) determines $P$ symbols to be punctured from the $S$ received symbols such that the remaining unpunctured symbols fit into the frame, (3) computes the puncture distances of $D1$ through $DN$ based on S and $P$, (4) determines $P1$ through $PN$ symbol punctures to be performed at the distances of $D1$ through $DN$, respectively, and (5) performs $P1$ through $PN$ symbol punctures on the $S$ received symbols at the puncture distances of $D1$ through $DN$, respectively. The symbol puncturing element can be designed to implement various features described above (e.g., distribute the $P1$ and $P2$ punctures over the entire frame). Again, each of the puncture distances of $D1$ through $DN$ can be selected to be greater than or equal to a minimum puncture distance $Dmin$ defined above.

The transmit data processor can further include a symbol repeating element that couples to the encoder and the symbol puncturing element. The symbol repeating element receives the code symbols from the encoder and repeats each received code symbol $M$ times to generate the $S$ symbols, with $M$ being an integer greater than or equal to one.

Yet another embodiment of the invention provides a receiver unit for use in a communications system. The receiver unit includes a receiver, a demodulator, and a receive data processor coupled in cascade. The receiver receives and processes a modulated signal to provide a number of samples for each received frame. The demodulator processes the samples to provide $N$ symbols for each received frame. The receive data processor (1) receives the $N$ symbols, (2) determines that $P$ symbol punctures had been performed on $S$ symbols to generate the $N$ received symbols, (3) computes a number of puncture distances, $D1$ through $DN$, based on $S$ and $P$, (4) determines $P1$ through $PN$ symbol punctures that had been performed at the distances of $D1$ through $DN$, respectively, (5) derives a puncturing pattern (e.g., based on $D1$ through $DN$, and $P1$ through $PN$) used to puncture the $S$ symbols to generate the $N$ received symbols, (6) inserts $P$ erasures among the $N$ received symbols in accordance with the derived puncturing pattern to generate $S$ recovered symbols, and (7) decodes the $S$ recovered symbols with a particular decoding scheme.

In one aspect of the invention, a method for puncturing symbols in a communications system is provided. The method advantageously includes receiving a number of symbols $S$ to be fitted into a frame having a capacity of $N$ symbols, wherein $S$ is greater than $N$; determining a number of symbols $P$ to be punctured from among the $S$ received symbols such that remaining unpunctured symbols fit into the frame; puncturing a symbol; incrementing a modulo-$S$ accumulator value by the number $P$ a number of times that is equal to the number $S$; and puncturing another symbol each time the modulo-$S$ accumulator value is decreased.

In another aspect of the invention, a transmit data processor for use in a communications system is provided. The transmit data processor advantageously includes an encoder operative to encode a plurality of data bits to generate a plurality of code symbols; and a symbol puncturing element operatively coupled to the encoder and operative to receive a number of symbols $S$ to be fitted into a frame having a capacity of $N$ symbols, wherein $S$ is greater than $N$, determine a number of symbols $P$ to be punctured from among the $S$ received symbols such that remaining unpunctured symbols fit into the frame, puncture a symbol, increment a modulo-$S$ accumulator value by the number $P$ a number of times that is equal to the number $S$, and puncture another symbol each time the modulo-$S$ accumulator value is decreased.

In another aspect of the invention, a transmit data processor for use in a communications system is provided. The transmit data processor advantageously includes a processor; and a storage medium coupled to the processor and containing a set of instructions executable by the processor to receive a number of symbols $S$ to be fitted into a frame having a capacity of $N$ symbols, wherein $S$ is greater than $N$, determine a number of symbols $P$ to be punctured from among the $S$ received symbols such that remaining unpunctured symbols fit into the frame, puncture a symbol, increment a modulo-$S$ accumulator value by the number $P$ a number of times that is equal to the number $S$, and puncture another symbol each time the modulo-$S$ accumulator value is decreased.

In another aspect of the invention, a method for puncturing symbols in a communications system is provided. The method advantageously includes the following steps: (a) receiving a number of symbols $S$ to be fitted into a frame having a capacity of $N$ symbols, wherein $S$ is greater than $N$; (b) determining a number of symbols $P$ to be punctured from among the $S$ received symbols such that remaining unpunctured symbols fit into the frame; (c) subtracting the number $S$ from an accumulator value if the accumulator value is greater than or equal to the number $S$; (d) puncturing a symbol; (e) incrementing the accumulator value by the number $P$; and (h) repeating steps (c)-(e) a number of times that is equal to the number $S$.

Other aspects and embodiments of the invention are described below.

**BRIEF DESCRIPTION OF THE DRAWINGS**

The features, nature, and advantages of the present invention will become more apparent from the detailed description set forth below when taken in conjunction with the drawings in which like reference characters identify correspondingly throughout and wherein:

FIG. 1 is a simplified block diagram of a communications system in which the present invention may be implemented;
FIG. 2 is a block diagram of a transmit data processor that can be designed to implement some embodiments of the present invention;

FIG. 3A is a flow diagram of a conventional symbol puncturing technique, which is described in the CDMA-2000 standard;

FIGS. 3B and 3C are diagrams that show two simple puncturing examples using the conventional symbol puncturing technique described in FIG. 3A;

FIG. 4A is a flow diagram of a symbol puncturing technique ;

FIG. 4B is a diagram that shows a puncturing example using the symbol puncturing technique described in FIG. 4A;

FIG. 5A is a flow diagram of another symbol puncturing technique ;

FIG. 5B is a diagram that shows a puncturing example using the symbol puncturing technique described in FIG. 5A; and

FIG. 6 shows plots of the performance achieved with the conventional puncturing technique versus the above puncturing technique.

FIG. 7 is a flowchart of an embodiment method of puncturing symbols.

**DETAILED DESCRIPTION OF THE SPECIFIC EMBODIMENTS**

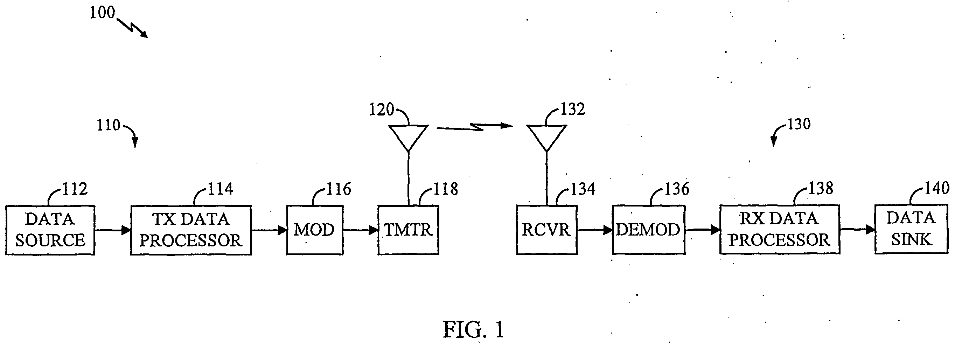

FIG. 1 is a simplified block diagram of an embodiment of a communications system 100 in which the present invention may be implemented. At a transmitter unit 110, traffic data is sent, typically in frames or packets, from a data source 112 to a transmit (TX) data processor 114 that formats, encodes, and interleaves (i.e., reorders) the data in accordance with a particular processing scheme. TX data processor 114 typically further processes signal and control data (e.g:, pilot and power control data). A modulator (MOD) 116 then receives, channelizes (i.e., covers), and spreads the processed data to generate symbols that are then converted to analog signals. The analog signals are filtered, quadrature modulated, amplified, and upconverted by a transmitter (TMTR) 118 to generate a modulated signal, which is then transmitted via an antenna 120 to one or more receiver units.

At a receiver unit 130, the transmitted signal is received by an antenna 132 and provided to a receiver (RCVR) 134. Within receiver 134, the received signal is amplified, filtered, downconverted, quadrature demodulated, and digitized to provide data samples. The samples are despread, decovered, and demodulated by a demodulator (DEMOD) 136 to generate demodulated symbols. A receive (RX) data processor 138 then reorders and decodes the demodulated symbols to recover the transmitted data. The processing performed by demodulator 136 and RX data processor 138 is complementary to the processing performed at transmitter unit 110. The recovered data is then provided to a data sink 140.

The signal processing described above supports transmissions of voice, video, packet data, messaging, and other types of communication in one direction. A bi-directional communications system supports two-way data transmission. However, the signal processing for the other direction is not shown in FIG. 1 for simplicity.

Communications system 100 can be a code division multiple access (CDMA) system, a time division multiple access (TDMA) communications system (e.g., a GSM system), a frequency division multiple access (FDMA) communications system, or other multiple access communications system that supports voice and data communication between users over a terrestrial link.

The use of CDMA techniques in a multiple access communications system is disclosed in U.S. Patent No. 4,901,307, entitled "SPREAD SPECTRUM MULTIPLE ACCESS COMMUNICATION SYSTEM USING SATELLITE OR TERRESTRIAL REPEATERS," and U.S. Patent No. 5,103,459, entitled "SYSTEM AND METHOD FOR GENERATING WAVEFORMS IN A CDMA CELLULAR TELEPHONE SYSTEM". Another specific CDMA system is disclosed in U.S. Patent Application Serial No. 08/963,386, entitled "METHOD AND APPARATUS FOR HIGH RATE PACKET DATA TRANSMISSION," filed November 3, 1997 (hereinafter referred to as the HDR system). These patents and patent application are assigned to the assignee of the present invention.

CDMA systems are typically designed to conform to one or more standards such as the "TIA/EIA/IS-95-A Mobile Station-Base Station Compatibility Standard for Dual-Mode Wideband Spread Spectrum Cellular System" (hereinafter referred to as the IS-95-A standard), the "TIA/EIA/IS-98 Recommended Minimum Standard for Dual-Mode Wideband Spread Spectrum Cellular Mobile Station" (hereinafter referred to as the IS-98 standard), the standard offered by a consortium named "3rd Generation Partnership Project" (3GPP) and embodied in a set of documents including Document Nos. 3G TS 25.211, 3G TS 25.212, 3G TS 25.213, and 3G TS 25.214 (hereinafter referred to as the W-CDMA standard), and the "TR-45.5 Physical Layer Standard for cdma2000 Spread Spectrum Systems" (hereinafter referred to as the CDMA-2000 standard). New CDMA standards are continually proposed and adopted for use.

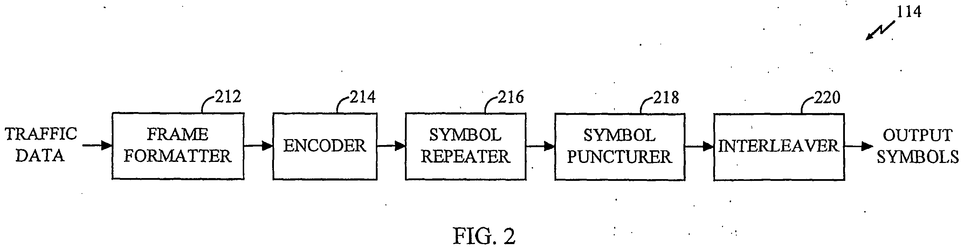

FIG. 2 is a block diagram of an embodiment of TX data processor 114, which can be designed to implement some embodiments of the present invention. Traffic data is received (again, typically in frames or packets) by a frame formatter 212 that formats each received frame in a particular manner. For example, frame formatter 212 can perform cycle redundancy check (CRC) coding on each frame of data and append the CRC bits to the frame. Frame formatter 212 typically further adds a number of code-tail bits to the end of each frame. The code-tail bits typically have values of zero and are used to set the subsequent encoder to a known state (e.g., all zeros) after the frame has been coded.

Other frame formatting functions may also be performed by frame formatter 212.

The formatted frames are then provided to an encoder 214 that codes each frame with a particular coding scheme to generate a corresponding frame of code symbols. For example, encoder 214 may perform convolutional or Turbo coding of a data frame. The particular coding scheme used is dependent on the particular system or standard being implemented and may be selectable (e.g., different coding schemes may be used for different types of services). The coding schemes used for the CDMA-2000 and W-CDMA systems are described in detail in the aforementioned standard documents.

The coded frames are then provided to a symbol repeater 216. Depending on the number of code symbols generated for a particular frame and the capacity of the frame, zero or more symbols may be repeated. For example, in accordance with the CDMA-2000 standard, each symbol in a particular frame is repeated an integer number of time (i.e., $M$ = 1, 2, 3, and so on), with the integer number $M$ being selected such that the number of symbols after repetition minimally exceeds the capacity of the frame. Thus, if $L$ code symbols are generated by encoder 214 for a particular frame and the frame has a capacity of $N$ symbols (where $N \geq L$), then each symbol in the frame is repeated M times, where $M$ is computed as $M = \lceil N/L \rceil$. The symbol "$\lceil \ \rceil$" represents a ceiling operator, which provides the next greater integer. For example, if $N / L$ = 5.2, then $\lceil N / L \rceil$ = 6.

In many instances, the number of code symbols after repetition is not equal fo the frame size (i.e., the number of code symbols exceeds the capacity of the frame). When this occurs, some of the code symbols are deleted (i.e., punctured) so that the resultant number of code symbols matches the capacity of.the frame. Symbol repetition and puncturing are described in further detail below.

The punctured frames are then provided to an interleaver 220. The code symbols for each frame are typically written to interleaver 220 in a particular write order (e.g., sequentially) and, after an entire frame has been stored, the code symbols are retrieved in a particular read order that is typically different from the write order to achieve the reordering of the symbols. Again, the interleaving scheme is typically defined by the particular system or standard being implemented.

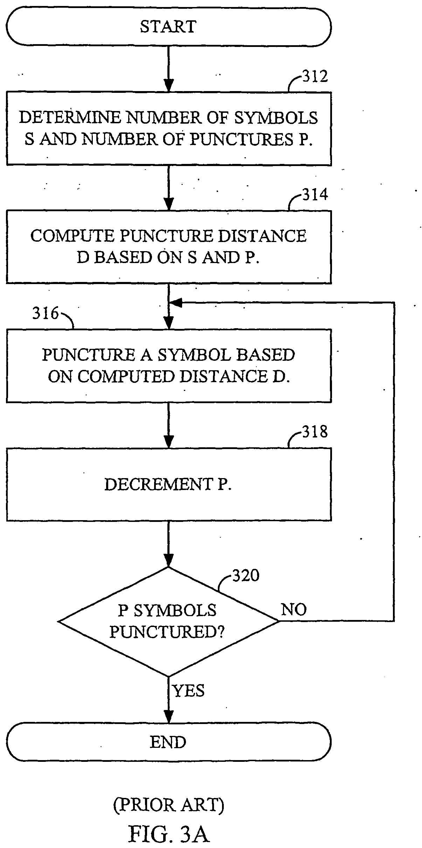

FIG. 3A is a flow diagram of a conventional symbol puncturing technique, which is described in the CDMA-2000 standard. Initially, the number of generated code symbols $S$ and the number of required punctures $P$ for a particular frame are determined, at step 312. Referring back to FIG. 2, $S$ code symbols are generated by symbol repeater 216 for a particular frame. If the frame has a capacity of $N$ symbols and if $S \geq N$, then $P$ symbols are punctured, where $P = S - N$. If $P$ is equal to zero then puncturing is not required. Otherwise, a puncture distance $D$ is computed, at step 314, based on the determined number of symbols $S$ and the number of punctures $P$. The puncture distance is the number of symbols between two consecutive puncture symbols, plus 1, wherein the first puncture occurs at the $D^{th}$ symbol in the frame. For example, if $D$ = 3, then there would be two unpunctured symbols before the next puncture. In accordance with the CDMA-2000 standard, the puncture distance $D$ is computed as:

$$D = \left\lfloor \frac{S}{P} \right\rfloor , \qquad\qquad \text{Eq (1)}$$

where the symbol "$\lfloor \ \rfloor$" denotes the floor operator, which provides the next lower integer. For example, if $S / P$ = 5.2, then $\lfloor S / P \rfloor$ = 5.

Symbols in the frame are then punctured using the computed distance $D$. To perform a symbol puncture, symbols in the frame are counted, starting with the first symbol, and the $D^{th}$ symbol is punctured, at step 316. After a symbol has been punctured, the number of required punctures $P$ is decremented, at step 318. A determination is then made whether all $P$ symbols have been punctured, at step 320. This determination can be made by simply checking whether $P$ = 0. If all $P$ symbols have been punctured, the process termiriates. Otherwise, the process returns to step 316 and another symbol is punctured, again based on the previously computed distance $D$.

The conventional symbol puncturing technique described in FIG. 3A can provide varied punctured results, depending on the particular values of $S$ and $P$. Specifically, the punctured symbols may be evenly distributed throughout the frame for some values of $S$ and $P$, or may be concentrated in one portion of the frame for some other values of $S$ and $P$. These varied punctured results can be illustrated by the following simple examples.

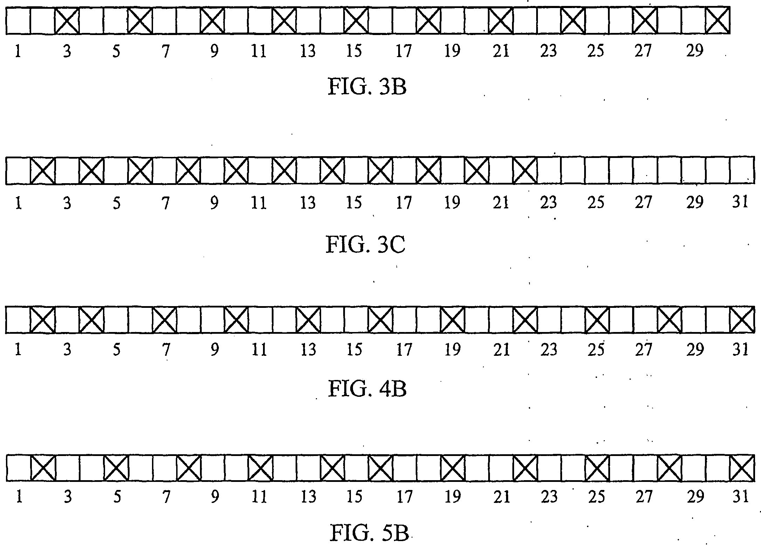

FIG. 3B is a diagram that illustrates a simple example using the conventional symbol puncturing technique described in FIG. 3A. In this specific example, 30 symbols are generated (i.e., $S$ = 30) but (for this example) only 20 symbols can be fitted into a frame (i.e., $N$ = 20). Thus, 10 symbols need to be punctured (i.e., $P = S - N = 30 - 20 = 10$). Using equation (1), the puncture distance $D$ can be computed as 3. As shown in FIG. 3B, every 3rd symbol is punctured, as represented by the boxes with the X. In this specific example, the punctured symbols are uniformly distributed across the entire frame.

FIG. 3C is a diagram that illustrates another simple example using the conventional symbol puncturing technique, but for different values of $S$ and $P$. In this specific example, 31 symbols are generated (i.e., $S$ = 31) and 20 symbols may be fitted into a frame (i.e., $N$ = 20). Thus, 11 symbols need to be punctured (i.e., $P$ = 11). Using equation (1), the puncture distance $D$ can be computed as 2. As shown in FIG. 3C, every $2^{nd}$ symbol is punctured, as represented by the boxes with the X, until all 11 symbols have been punctured. After the $11^{th}$ symbol has been punctured, the remaining symbols are passed unmodified. As shown in this specific example, the punctured symbols are concentrated toward the front portion of the frame, while the back portion of the frame is left unchanged. The uneven distribution of punctured symbols results from puncturing the symbols with a high puncture rate (i.e., a short puncture distance $D$).

FIGS. 3B and 3C illustrate the varied punctured results that can be obtained using the conventional puncturing technique. The puncturing pattern changes from a uniform distribution in FIG. 3B to an uneven distribution in FIG. 3C as a result of simply increasing the number of code symbols S by one. The conventional puncturing technique thus has "critical" points in which, because of the discrete floor operator $\lfloor \rfloor$, the puncturing distance D changes by one whole unit when S is increased by one.

The uneven distribution of the punctured symbols in FIG. 3C can result in performance degradation at the receiver unit. Deletion of symbols is equivalent to reducing the transmit power for those symbols to zero. For convolutionally coded data, a Viterbi decoder is used at the receiver unit to decode the symbols. The Viterbi decoder provides improved performance (i.e., better error correcting capability) if code symbols received in error are more uniformly spread across an entire frame. By puncturing more symbols in one portion of a frame, the Viterbi decoder may not be able to correct symbol errors in that portion of the frame, and an entire frame may be declared erased (i.e., received in error).

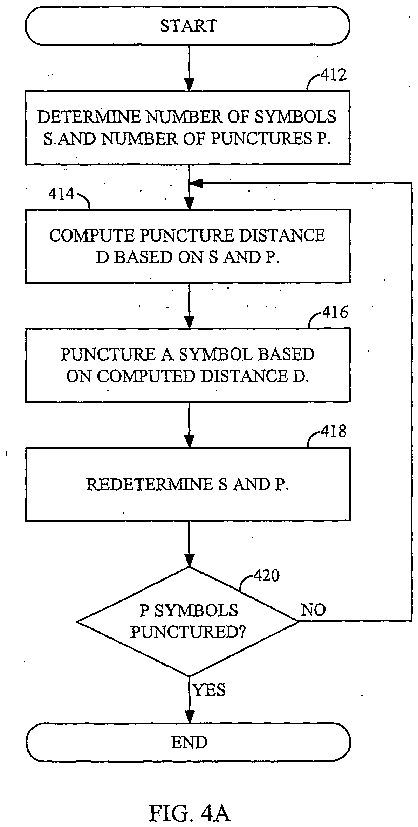

FIG. 4A is a flow diagram of an example of a symbol puncturing technique. Initially, the number of generated code symbols $S$ and the number of required punctures $P$ for a particular frame are determined, at step 412. If the frame has a capacity of $N$ symbols and if $S \geq N$, then $P$ symbols are punctured, where $P = S - N$. If $P$ is equal to zero then puncturing is not required. Otherwise, the puncture distance $D$ is computed based on the determined number of symbols $S$ and the number of punctures $P$, at step 414. The puncture distance $D$ can be computed using equation (1).

Symbols in the frame are then punctured using the computed distance $D$. To perform a symbol puncture, symbols in the frame are counted, initially starting with the first symbol, and the $D^{th}$ symbol is punctured, at step 416. After a symbol has been punctured, the number of remaining symbols is determined (i.e., $S_{n+1} = S_n - D$) and the number of required punctures $P$ is decremented (i.e., $P_{n+1} = P_n - 1$), at step 418. A determination is then made whether all $P$ symbols have been punctured, at step 420. Again, this determination can be made by simply checking whether $P = 0$. If all $P$ symbols have been punctured, the process terminates. Otherwise, the process returns to step 414 and the puncture distance $D$ is recomputed based on the updated values for $S$ and $P$. Symbols are counted from there onwards and the $D^{th}$ symbol is punctured, at step 416. The process then continues until all $P$ symbols have been punctured.

The symbol puncturing technique shown in FIG. 4A recomputes the puncture rate (i.e., the puncture distance $D$) in "real-time" after each puncture. The new "puncture distance" (i.e., the number of symbols until the next puncture) is computed based on the number of symbols still remaining and the number of punctures still to be performed. Each computation generates a new puncture distance $D$ that attempts to uniformly distribute the remaining symbol punctures.

For a clearer understanding, the puncturing technique described in FIG. 4A can be applied to the example shown in FIG. 3B in which 31 code symbols are generated (i.e., $L = 31$) and the frame has a capacity of 20 symbols (i.e., $N = 20$). Again, 11 symbol punctures are required. Table 1 lists the parameters $S$, $P$, and $D$ for each puncture (i.e., for each pass through the loop shown in FIG. 4A).

Table 1

| Parameters | S | P | D |
|---|---|---|---|
| start | 31 | 11 | $D = \lfloor 31/11 \rfloor = 2$ |
| After $1^{st}$ puncture | 29 | 10 | $D = \lfloor 29/10 \rfloor = 2$ |
| After $2^{nd}$ puncture | 27 | 9 | $D = \lfloor 27/9 \rfloor = 3$ |
| After $3^{rd}$ puncture | 24 | 8 | $D = \lfloor 24/8 \rfloor = 3$ |
| After $4^{th}$ puncture | 21 | 7 | $D = \lfloor 21/7 \rfloor = 3$ |
| After $5^{th}$ puncture | 18 | 6 | $D = \lfloor 18/6 \rfloor = 3$ |
| After $6^{th}$ puncture | 15 | 5 | $D = \lfloor 15/5 \rfloor = 3$ |
| After $7^{th}$ puncture | 12 | 4 | $D = \lfloor 12/4 \rfloor = 3$ |
| After $8^{th}$ puncture | 9 | 3 | $D = \lfloor 9/3 \rfloor = 3$ |
| After $9^{th}$ puncture | 6 | 2 | $D = \lfloor 6/2 \rfloor = 3$ |
| After $10^{th}$ puncture | 3 | 1 | $D = \lfloor 3/1 \rfloor = 3$ |

FIG. 4B is a diagram that shows the results of the puncturing example described in Table 1. For the first two punctures, the distance is computed as two (i.e., $D = 2$). After the second symbol puncture, the remaining symbols are punctured with a distance of three (i.e., $D = 3$). When comparing the puncture pattern shown in FIG. 4B versus the puncture pattern shown in Fig. 3C, it can be observed that the symbol puncturing technique of the invention provides a much more even distribution of punctured symbols.

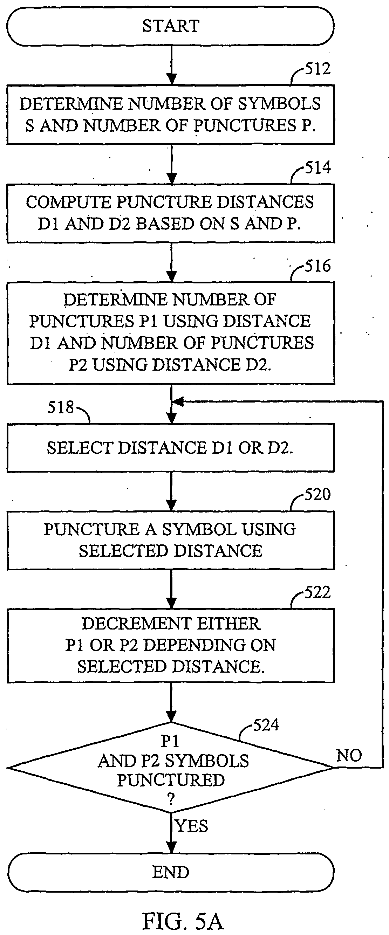

FIG. 5A is a flow diagram of an example of another symbol puncturing technique. Initially, the number of generated code symbols S and the number of required punctures P for a particular frame are determined, at step 512. Again, if the frame has a capacity of N symbols and if $S \geq N$, then P symbols are punctured, where $P = S - N$. If P is equal to zero then puncturing is not required. Otherwise, two puncture distances D1 and D2 are computed, at step 514, based on the determined number of symbols S and the number of punctures P.

For every integer S and P, the following equality can be shown to be true:

$$P \left\lfloor \frac{S}{P} \right\rfloor \leq S \leq P \left\lceil \frac{S}{P} \right\rceil . \qquad\qquad \text{Eq (2)}$$

Based on equation (2), two puncture distances D1 and D2 can be computed as:

$$D1 = \left\lfloor \frac{S}{P} \right\rfloor , \text{ and} \qquad\qquad \text{Eq (3)}$$

$$D2 = \begin{cases} D1 & if \ D1 * P = S \\ D1 + 1 & otherwise. \end{cases} \qquad\qquad \text{Eq (4)}$$

From equations (3) and (4), D1 can be computed with one division operation and D2 can be computed as $D1 + 1$. However, other values for D1 and D2 can also be selected and are within the scope of the invention. For example, D1 can be chosen to equal $\lfloor S / P \rfloor$ and D2 can be chosen to equal $\lceil S / P \rceil$.

The number of punctures P1 using puncture distance D1 and the number of punctures P2 using puncture distance D2 are then computed, at step 516. The number of punctures P1 and P2 can be computed as:

$$P2 = S - P * D1, \text{ and} \qquad\qquad \text{Eq (5)}$$

$$P1 = P - P2 . \qquad\qquad \text{Eq (6)}$$

The puncture distances D1 and D2 and the number of punctures P1 and P2 are related by the following:

$$S = P1 \cdot D1 + P2 \cdot D2 . \qquad\qquad \text{Eq (7)}$$

Once the puncture distances D1 and D2 and the number of punctures P1 and P2 have been computed, one of the computed puncture distances is selected, at step 518. Various methods can be used to select either D1 or D2, as described below. A symbol in the frame is then punctured using the selected puncture distance. Again, to perform a symbol puncture, symbols in the frame are counted, starting with first symbol in the frame or the last punctured symbol, and the $D1^{th}$ or $D2^{th}$ symbol is punctured, at step 520. After a symbol has been punctured, the required number of punctures P1 or P2 is decremented, depending on which puncture distance has been selected, at step 522 Specifically, P1 is decremented if D1 is selected and P2 is decremented if D2 is selected.

A determination is then made whether all P1 and P2 symbols have been punctured, at step 524. This determination can be made by simply checking whether $P1 = 0$ and $P2 = 0$. If all P1 and P2 symbols have been punctured, the process terminates. Otherwise, the process returns to step 518 and one of the puncture distances is selected. The process then continues until all P1 and P2 symbols have been punctured.

For a better understanding, the puncturing technique described in FIG. 5A can be applied to the specific example described above in which 31 symbols are generated (i.e., $S = 31$), 20 symbols may be fitted into a frame (i.e., $N = 20$),

and 11 symbols need to be punctured (i.e., *P* = 11). Using equations (3) and (4), the puncture distances *D1* and *D2* can be computed as:

$$D1 = \lfloor 31/11 \rfloor = 2, \text{ and}$$

$$D2 = \lceil 31/11 \rceil = 3,$$

respectively. Using equations (5) and (6), the number of punctures at distances *D2* and *D1* can be computed as:

$$P2 = 31 - 11\lfloor 31/11 \rfloor = 9 \text{ , and}$$

$$P1 = 11 - 9 = 2 \text{ ,}$$

respectively. Thus, two punctures are performed at the distance of two and nine punctures are performed at the distance of three.

As noted above, various methods can be used to select which one of the puncture distances, *D1* or *D2*, to use for the next puncture. In one example one of the puncture distances (e.g., *D1*) is selected and used for a corresponding number of times (e.g., *P1*) and then the other puncture distance (e.g., *D2*) is selected and used for the remaining punctures (e.g., *P2*). For the above example, two punctures (*P1*) can be performed at the distance of two (*D1*) followed by nine punctures (*P2*) at the distance of three (*D2*).

In another example, the puncture distances *D1* and *D2* are alternately selected and used until all punctures at one of the distances are achieved. The remaining punctures are then performed using the other distance. For the above example, the punctures can be performed using the distances of 2, 3, 2, 3, 3, 3, and so on.

In yet another example, the *P1* punctures at the distance of *D1* are approximately distributed among the *P2* punctures at the distance of *D2*. For example, if the ratio of *P1* to *P2* is *R*, then *R* punctures are performed using the distance *D1* for each puncture using the distance *D2*. For the above example, two punctures are performed using the distance of two and nine punctures are performed using the distance of three. Thus, four or five punctures can be performed using the distance of three for each puncture at the distance of two.

In yet another example, a weighting algorithm can be used to distribute the *P1* punctures at the distance of *D1* among the *P2* punctures at the distance of *D2*. Let intermediate value *F = P1\*N2 - P2\*N1*, wherein *N1* and *N2* are incremental counters indicating the number of punctures at an iterative round. The maximum values for *N1* and *N2* are chosen so that the puncturing distances *P1* and *P2* are distributed within the frame. At the beginning of every frame and after every puncture, and while *N1 + N2 < P*, the distance *D2* is chosen and *N2* is incremented by 1 if *F < 0*, otherwise the distance *D1* is chosen and *N1* is incremented by 1.

In the embodiment of the present invention the symbol punctures are (approximately) uniformly distributed over the entire frame. In one specific implementation of this embodiment, a "wrap-around" accumulator can be used to store a value that is then used to select the puncture distance for the next puncture. The accumulator is designed to store a value ranging from zero to *B*, where *B* is typically a power of twos (e.g., 256, 512, 1024, or some other value). B may also be selected to be larger than or equal to the size of the frame (i.e., $B \geq N$). Initially, the smaller value of the punctures *P1* and *P2* is determined. Then an accumulation value *A* is computed as the ratio of the smaller *P1* or *P2* value to the larger *P1* or *P2* value, multiplied by the value *B*. For example, if *P1* = 2, *P2* = 9, and *B* = 1024, then *A* = (*P1/P2*) · *B* = (2/9)•1024 $\cong$ 227. Thereafter, before each puncture, the accumulation value A is added to the value in the accumulator and stored back to the accumulator. If the accumulator wraps around after the accumulation with the value *A*, then the puncture distance corresponding to the smaller *P1* or *P2* value is selected for the next symbol puncture.

For the above example, the values in the accumulator can be computed as 227, 454, 681, 908, 111, 338, 565, 792, 1019, 222, and 449, before the 1st, 2nd, 3rd, 4th, 5th, 6th, 7th, 8th, 9th, 10th, and 11th symbol punctures, respectively. The puncture distance *D1* is selected for the 5th and 10th symbol punctures since the accumulator has wrapped around and has values of 111 and 222, respectively. By initializing the accumulator with a value other than zero, the first puncture at the distance of two can be different. For example, if the accumulator is initialized a the value of 512, then the 3rd and 7th punctures are performed at the distance of two and the remaining punctures are performed at the distance of three.

For the example shown in FIG. 5A, the computational costs are maintained low. Specifically, only one division operation is performed at step 514 to compute the puncture distances *D1* and *D2*, which is the same number of division operation as for the conventional puncturing technique shown in FIG. 3A. Thus, the example shown in FIG. 5A provides improved performance at equivalent computation costs.

FIG. 5B is a diagram that shows the results of the puncturing example described above using the symbol puncturing technique shown in FIG. 5A. In this diagram, the $1^{st}$ and $6^{th}$ punctures are performed using the distance of two and the other punctures are performed using the distance of three. The punctures at distances $D1$ and $D2$ can also be distributed in various other manners, some of which are described above.

The symbol puncturing technique of the invention described in FIG. 5A can be generalized to cover $N$ puncture distances. The $N$ puncture distances $D1$ through $DN$ can be computed based on $S$ and $P$ (and possibly other parameters) and used to puncture $S$ code symbols. For improved puncturing results (e.g., a more even distribution of the symbol punctures), each of the distances $D1$ through $DN$ can be selected to be greater than or equal to a minimum puncture distance $Dmin$ defined as:

$$D\min = \left\lfloor \frac{S}{P} \right\rfloor . \qquad\qquad \text{Eq (8)}$$

However, deviations from the above condition can be made and are within the scope of the present invention.

For the $N$ puncture distances, the number of symbol punctures to be performed at each of the puncture distances $D1$ through $DN$ is then determined. The $P1$ through $PN$ symbol punctures at the distances of $D1$ through $DN$, respectively, are selected such that the following conditions are satisfied:

$$P = \sum_{x=1}^{N} Px \ , \text{and} \qquad\qquad \text{Eq (9)}$$

$$S = \sum_{x=1}^{N} Px \cdot Dx \ . \qquad\qquad \text{Eq (10)}$$

$P1$ through $PN$ symbol punctures are then performed at the distances of $D1$ through $DN$, respectively.

As noted above, a complementary process is performed at the receiver unit to account for the symbol puncturing performed at the transmitter unit. Specifically, erasures (i.e., "don't knows") are inserted in place of symbols that have been punctured. The erasures are given appropriate weighting during the subsequent decoding process.

Prior to the decoding, $N$ code symbols are received for a particular frame. The number of symbol punctures $P$ that had been performed among $S$ code symbols to generate the $N$ received symbols are then determined. A number of puncture distances, $D1$ through $DN$, is then computed based on $S$ and $P$. $P1$ through $PN$ symbol punctures that had been performed at the distances of $D1$ through $DN$, respectively, are also determined. A puncturing pattern used to puncture the $S$ symbols to generate the $N$ received symbols is then derived based on the $P1$ through $PN$ symbol punctures at the distances of $D1$ through $DN$, respectively. $P$ erasures are then inserted among the $N$ received symbols based on the derived puncturing pattern to generate $S$ recovered symbols, which are then decoded with a particular decoding scheme. Again, for a more even distribution of the erasures/symbol punctures, each of the distances $D1$ through $DN$ can be selected to be greater than or equal to a minimum puncture distance $Dmin$ defined above.

As a simple example, for the example which $P1$ symbol punctures at the distance of $D1$ are performed followed by $P2$ symbol punctures at the distance of $D2$, the receiver unit inserts $P1$ erasures, one after each $D1^{th}$ received symbols, then inserts $P2$ erasures, one after each $D2^{th}$ received symbols. The S recovered symbols are then decoded with a particular decoding scheme complementary to the coding scheme used at the transmitter unit.

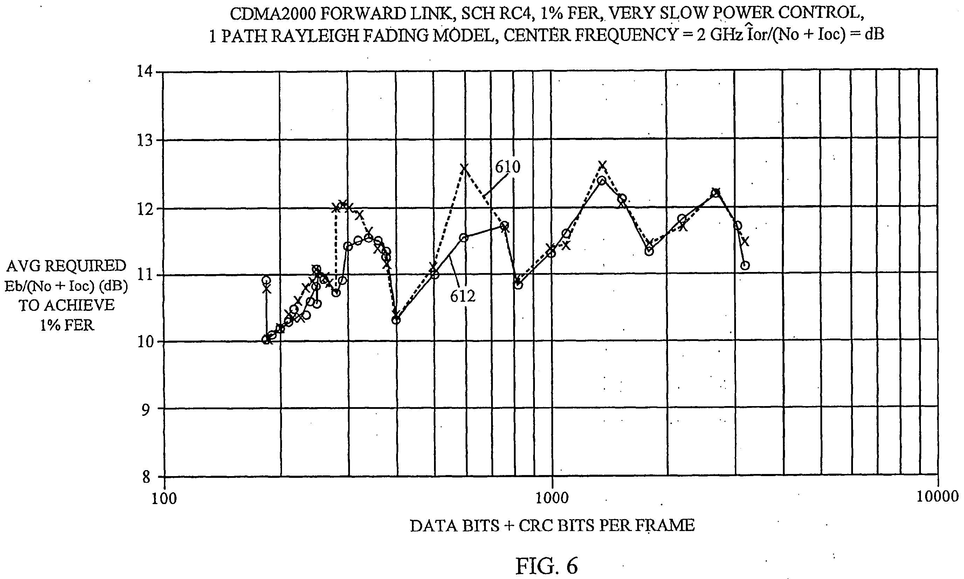

FIG. 6 shows plots of the performance achieved with the conventional puncturing technique described in FIG. 3A versus the example puncturing technique. The performance results are for the forward link (i.e., from a base station to a user terminal) in the CDMA-2000 system. The horizontal axis represents the number of data and CRC bits for each frame. For the CDMA-2000 system, frames of various sizes are available for use, with the frame sizes being an integer multiple of a basic frame size (e.g., available frame sizes are $768 \cdot K$, where $K$ = 1, 2, ...). The vertical axis represents the average required energy-per-bit-to-total-noise-plus-interference $Eb/(No + Ioc)$ for a frame error rate (FER) of 1%.

The simulation results for the conventional puncturing technique are shown by a dashed line 610 in FIG. 6. The results indicate some peaks at approximately periodic intervals. For example, peaks are observed at approximately 300, 600, 1200, and 2400 bits. These peaks result from the uneven symbol puncturing generated by the conventional puncturing technique. The peaks represent the need for a higher average energy per bit $Eb$ to maintain the same FER of 1%.

The simulation results for the puncturing technique of the invention are shown by a solid line 612 in FIG. 6. The results indicate improvement in performance at some of the peaks. In particular, improvements of approximately 0.5 dB and 1.0 dB are observed at 300 and 600 bits, respectively.

In the embodiment of the present invention puncturing may be advantageously performed without using numbers of symbol punctures *P1* and *P2* or puncture distances *D1* and *D2*. An accumulator is configured to wrap around after it has been incremented to a value that is greater than or equal to *S,* each increment being of size *P,* wherein *P* is a desired number of symbol punctures, *S* is a total number of received symbols, and *N* is a frame capacity in symbols (i.e., a number of symbols remaining after puncturing). The accumulator is thus a modulo-*S* accumulator. A symbol index is advantageously initialized to one. The symbol index is incremented by one each time the accumulator is incremented by *P,* until the symbol index reaches the value *S.* The process is advantageously begun with a puncture. Each time the accumulator wraps around, a puncture is performed. Nevertheless, one of ordinary skill in the art would readily appreciate that the process need not be initiated with a puncture. Additionally, while the accumulator is advantageously initialized to *S,* those of skill would understand that the accumulator may be initialized to any value, such as, e.g., zero. Moreover, those of skill would appreciate that the process may instead be run in reverse, so that the symbol index is initially set to the value *S,* and decremented by one each time the accumulator is incremented by *P,* until the symbol index reaches one.

In an example of the just-described embodiment, ten symbols are received and the frame capacity is only seven symbols, so three symbols must be punctured. Accordingly, *P* is 3, *N* is seven, and *S* is ten. The values for the accumulator and the symbol index are shown Table 2 below.

Table 2

| Accumulator Value (Initialized to 10) | Symbol Index (Initialized to 1) |
|---|---|
| 0 (10-10) | PUNCTURE (X) |
| 3 | 2 |
| 6 | 3 |
| 9 | 4 |
| 2 (12-10) | PUNCTURE (X) |
| 5 | 6 |
| 8 | 7 |
| 1 (11-10) | PUNCTURE (X) |
| 4 | 9 |
| 7 | 10 |
| 0 | STOP |

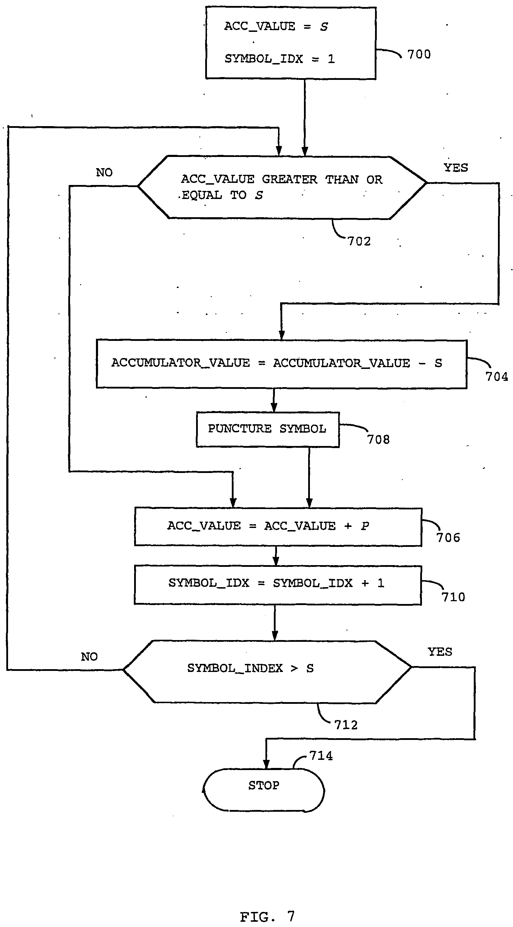

A flowchart illustrating algorithm steps in accordance with the just-described embodiment is shown in FIG. 7. In step 700 a field denoted ACC_VALUE is initialized to the value *S,* and a field denoted SYMBOL_IDX is initialized to one. In other embodiments ACC_VALUE is initialized to values other than *S,* such as, e.g., zero. Control flow then proceeds to step 702. In step 702 ACC_VALUE is compared with the number *S.* If ACC_VALUE is greater than or equal to *S,* control flow proceeds to step 704. If, on the other hand, ACC_VALUE is not greater than or equal to *S,* control flow proceeds to step 706. In step 704 ACC_VALUE is decremented by *S* (i.e., ACC_VALUE is set equal to the difference between ACC_VALUE and *S*). Control flow then proceeds to step 708. In step 708 a symbol corresponding to the value of SYMBOL_IDX is punctured. Control flow then proceeds to step 706. In step 706 ACC_VALUE is incremented by *P* (i.e., ACC_VALUE is set equal to the sum of ACC_VALUE and *P*). Control flow then proceeds to step 710. In step 710 SYMBOL_IDX is incremented by one (i.e., SYMBOL_IDX is set equal to the sum of SYMBOL_IDX and one). Control flow then proceeds to step 714. In step 714 SYMBOL_IDX is compared with the value *S.* If SYMBOL_IDX is greater than *S,* control flow proceeds to step 712, at which the process stops. If, on the other hand, SYMBOL_IDX is not greater than *S,* control flow returns to step 702 and the process continues. In other embodiments SYMBOL_IDX is initialized to the value *S* and the algorithm terminates when SYMBOL_IDX drops below the one.

In an alternate embodiment, wherein the values *S* and *P* have a common denominator *M,* the value *S/M* may be substituted for the value *S,* and the value *P/M* may be substituted for the value *P in* the flowchart of FIG. 7 for ACC_VALUE field (but not in the SYMBOL_IDX field). Accordingly, the ACC_VALUE field is initialized to *S/M* and a modulo-*S/M* register is used for the accumulator. The accumulator is incremented by *P/M* each increment. Every time the accumulator value exceeds *S/M,* a modulo-*S/M* operation is performed and a symbol puncture is done.

For clarity, some aspects of the invention have been described specifically for the forward link in the CDMA-2000 system. However, the invention can also be used in other communications systems that employ the same, similar, or different puncturing scheme. For example, the invention can be used to perform puncturing in the W-CDMA system and other CDMA systems. Moreover, the symbol puncturing technique of the present invention can also be used on the reverse link (i.e., from the user terminal to the base station). The puncturing techniques of the invention can be modified to be more suited for the specific system or standard in which it is used.

The symbol puncturing techniques of the invention can be implemented in various manners. For example, the puncturing techniques can be implemented in hardware within one or more application specific integrated circuits (ASICs), digital signal processors (DSPs), programmable logic device (PLD), controllers, micro-controllers, microprocessors, other electronic units designed to perform the functions described herein, or a combination thereof. Alternatively, the puncturing techniques of the invention can be implemented in software or firmware executed on a processor or controller. The puncturing techniques of the present invention can also be implemented in a combination of hardware and software.

The foregoing description of the embodiment is provided to enable any person skilled in the art to make or use the present invention. Various modifications to these embodiments will be readily apparent to those skilled in the art, and the generic principles defined herein may be applied to other embodiments without the use of the inventive faculty. Thus, the present invention is not intended to be limited to the embodiments shown herein but is to be accorded the widest scope consistent with the principles and novel features as claimed by the appended claims.

**Claims**

1. A method for puncturing symbols in a communications system comprising a processor and a storage medium coupled to the processor, the method comprising:

   (a) receiving a number of symbols S to be fitted into a frame having a capacity of N symbols, wherein S is greater than N;
   (b) determining a number of symbols P to be punctured from among the S received symbols such that remaining unpunctured symbols fit into the frame;
   (b1) initializing an accumulator value to S before puncturing the first symbol, wherein the accumulator provides a modulo-S operation;
   (b2) initializing a symbol index to 1 ;(c) if the accumulator value is greater than or equal to S, subtracting the number S from an accumulator value, and
   puncturing a symbol corresponding to the value of the symbol index;
   (d) incrementing the accumulator value by the number P and incrementing the symbol index by 1; and
   (e) repeating steps (c) and (d) a number of times that is equal to the number S.

2. A transmit data processor for use in a communication system, comprising:

   a processor; and
   a storage medium coupled to the processor and containing a set of instructions executable by the processor to

   (a) receive a number of symbols S to be fitted into a frame having a capacity of N symbols, wherein S is greater than N;
   (b) determine a number of symbols P to be punctured from among the S received symbols such that remaining unpunctured symbols fit into the frame;
   (b1) initialize an accumulator value to S before puncturing the first symbol, wherein the accumulator provides a modulo-S operation;
   (b2) initialize a symbol index to 1;
   (c) if the accumulator value is greater than or equal to S,

   subtract the number S from an accumulator value and
   puncture a symbol corresponding to the value of the symbol index;

   (d) increment the accumulator value by the number P and incrementing the symbol index by 1; and
   (e) repeat steps (c) and (d) a number of times that is equal to the number S.

**Patentansprüche**

1. Ein Verfahren zum Punktieren von Symbolen in einem Kommunikationssystem, das einen Prozessor und ein Speichermedium, welches an den Prozessor gekoppelt ist, aufweist, wobei das Verfahren Folgendes aufweist:

(a) Empfangen einer Anzahl von Symbolen S, die in einen Frame bzw. Rahmen eingepasst werden sollen, der eine Kapazität von N Symbolen hat, wobei S größer als N ist;
(b) Bestimmen einer Anzahl von Symbolen P, die punktiert werden sollen, aus den S empfangenen Symbolen, so dass verbleibende unpunktierte Symbole in den Rahmen passen;
(b1) Initialisieren eines Wertes eines Akkumulationselementes auf S, bevor das erste Symbol punktiert wird, wobei das Akkumulationselement eine modulo-S-Operation vorsieht;
(b2) Initialisieren eines Symbolindex auf 1;
(c) wenn der Wert des Akkumulationselementes größer als oder gleich S ist,
Subtrahieren der Anzahl S von einem Wert des Akkumulationselementes, und
Punktieren eines Symbols entsprechend dem Wert des Symbolindex;
(d) Inkrementieren des Wertes des Akkumulationselementes um die Anzahl P und Inkrementieren des Symbolindex um 1; und
(e) Wiederholen der Schritte (c) und (d) eine Anzahl von Malen, die gleich der Anzahl S ist.

2. Ein Sendedatenprozessor zur Verwendung in einem Kommunikationssystem, der Folgendes aufweist:

einen Prozessor; und
ein Speichermedium, das an den Prozessor gekoppelt ist und einen Satz von Instruktionen enthält, der durch den Prozessor ausgeführt werden kann zum

(a) Empfangen einer Anzahl von Symbolen S, die in einen Frame bzw. Rahmen eingepasst werden sollen, der eine Kapazität von N Symbolen hat, wobei S größer als N ist;
(b) Bestimmen einer Anzahl von Symbolen P, die punktiert werden sollen, aus den S empfangenen Symbolen, so dass verbleibende unpunktierte Symbole in den Rahmen passen;
(b1) Initialisieren eines Wertes eines Akkumulationselementes auf S vor dem Punktieren des ersten Symbols, wobei das Akkumulationselement eine modulo-S-Operation vorsieht;
(b2) Initialisieren eines Symbolindex auf 1;
(c) wenn der Wert des Akkumulationselementes größer als oder gleich S ist, Subtrahieren der Anzahl S von einem Wert des Akkumulationselementes und Punktieren eines Symbols entsprechend dem Wert des Symbolindex;
(d) Inkrementieren des Wertes des Akkumulationselementwertes um die Anzahl P und Inkrementieren des Symbolindex um 1; und
(e) Wiederholen der Schritte (c) und (d) eine Anzahl von Malen, die gleich der Anzahl S ist.

## Revendications

1. Procédé pour perforer des symboles dans un système de communication comprenant un processeur et un milieu de stockage couplé au processeur, le procédé comprenant :

(a) recevoir un nombre S de symboles devant tenir dans une trame ayant une capacité de N symboles, S étant supérieur à N ;
(b) déterminer un nombre P de symboles à perforer parmi les S symboles reçus de telle sorte que les symboles non perforés restants tiennent dans la trame ;
(b1) initialiser une valeur d'accumulateur à S avant de perforer le premier symbole, l'accumulateur assurant une opération modulo S ;
(b2) initialiser un index de symbole à 1 ;
(c) si la valeur d'accumulateur est supérieure ou égale à S,
soustraire le nombre S d'une valeur d'accumulateur, et
perforer un symbole correspondant à la valeur de l'index de symbole ;
(d) incrémenter la valeur d'accumulateur du nombre P et incrémenter l'index de symbole de 1 ; et
(e) répéter les étapes (c) et (d) un nombre de fois égal au nombre S.

2. Processeur de données d'émission pour utilisation dans un système de communication, comprenant :

un processeur ; et

un milieu de stockage couplé au processeur et contenant un ensemble d'instructions exécutables par le processeur pour :

(a) recevoir un nombre S de symboles devant tenir dans une trame ayant une capacité de N symboles, S étant supérieur à N ;

(b) déterminer un nombre P de symboles à perforer parmi les S symboles reçus de telle sorte que les symboles non perforés restants tiennent dans la trame ;

(b1) initialiser une valeur d'accumulateur à S avant de perforer le premier symbole, l'accumulateur assurant une opération modulo S ;

(b2) initialiser un index de symbole à 1 ;

(c) si la valeur d'accumulateur est supérieure ou égale à S,

soustraire le nombre S d'une valeur d'accumulateur, et

perforer un symbole correspondant à la valeur de l'index de symbole ;

(d) incrémenter la valeur d'accumulateur du nombre P et incrémenter l'index de symbole de 1 ; et

(e) répéter les étapes (c) et (d) un nombre de foiségal au nombre S.

FIG. 1

TRAFFIC DATA → **FRAME FORMATTER** (212) → **ENCODER** (214) → **SYMBOL REPEATER** (216) → **SYMBOL PUNCTURER** (218) → **INTERLEAVER** (220) → OUTPUT SYMBOLS

114

FIG. 2

EP 2 157 701 B1

```
                    ┌─────────────────────────┐
                    │          START           │
                    └─────────────────────────┘
                                 │
                                 ▼                    ⌐312
                    ┌─────────────────────────┐
                    │  DETERMINE NUMBER OF     │
                    │  SYMBOLS S AND NUMBER    │
                    │  OF PUNCTURES P.         │
                    └─────────────────────────┘
                                 │
                                 ▼                    ⌐314
                    ┌─────────────────────────┐
                    │  COMPUTE PUNCTURE        │
                    │  DISTANCE D BASED ON     │
                    │  S AND P.                │
                    └─────────────────────────┘
                                 │
             316                 ▼
                    ┌─────────────────────────┐
                    │  PUNCTURE A SYMBOL       │
                    │  BASED ON COMPUTED       │
                    │  DISTANCE D.             │
                    └─────────────────────────┘
                                 │
                                 ▼                    ⌐318
                    ┌─────────────────────────┐
                    │      DECREMENT P.        │
                    │                          │
                    └─────────────────────────┘
                                 │
                                 ▼        ⌐320
                           ◇─────────────◇
                          ╱   P SYMBOLS    ╲       NO
                          ╲   PUNCTURED?    ╱──────────►
                           ◇─────────────◇
                                 │ YES
                                 ▼
                    ┌─────────────────────────┐
                    │          END             │
                    └─────────────────────────┘
```

(PRIOR ART)

## FIG. 3A

FIG. 3B

FIG. 3C

FIG. 4B

FIG. 5B

START

412

DETERMINE NUMBER OF SYMBOLS
S AND NUMBER OF PUNCTURES P.

414

COMPUTE PUNCTURE DISTANCE
D BASED ON S AND P.

416

PUNCTURE A SYMBOL BASED
ON COMPUTED DISTANCE D.

418

REDETERMINE S AND P.

420

P SYMBOLS
PUNCTURED?

NO

YES

END

FIG. 4A

```
                    ┌─────────────────────────────┐
                    │            START            │
                    └─────────────────────────────┘
                                   │
                                   ▼              ╭512
                    ┌─────────────────────────────┐
                    │  DETERMINE NUMBER OF SYMBOLS │
                    │  S AND NUMBER OF PUNCTURES P.│
                    └─────────────────────────────┘
                                   │
                                   ▼              ╭514
                    ┌─────────────────────────────┐
                    │  COMPUTE PUNCTURE DISTANCES  │
                    │  D1 AND D2 BASED ON S AND P. │
                    └─────────────────────────────┘
                                   │
                                   ▼              ╭516
                    ┌─────────────────────────────┐
                    │      DETERMINE NUMBER OF     │
                    │  PUNCTURES P1 USING DISTANCE │
                    │  D1 AND NUMBER OF PUNCTURES  │
                    │     P2 USING DISTANCE D2.    │
                    └─────────────────────────────┘
                                   │
          518╮                     ▼◄─────────────────────────┐
                    ┌─────────────────────────────┐           │
                    │     SELECT DISTANCE D1 OR D2.│           │
                    └─────────────────────────────┘           │
                                   │                           │
                                   ▼              ╭520         │
                    ┌─────────────────────────────┐           │
                    │     PUNCTURE A SYMBOL USING  │           │
                    │        SELECTED DISTANCE     │           │
                    └─────────────────────────────┘           │
                                   │                           │
                                   ▼              ╭522         │
                    ┌─────────────────────────────┐           │
                    │      DECREMENT EITHER        │           │
                    │  P1 OR P2 DEPENDING ON       │           │
                    │     SELECTED DISTANCE.       │           │
                    └─────────────────────────────┘           │
                                   │                           │
                                   ▼              ╭524         │
                              ╱         ╲                      │
                            ╱     P1      ╲      NO            │
                          ╱  AND P2 SYMBOLS  ╲────────────────┘
                            ╲  PUNCTURED   ╱
                              ╲    ?    ╱
                                 ╲   ╱
                                   │ YES
                                   ▼
                    ┌─────────────────────────────┐
                    │            END              │
                    └─────────────────────────────┘
```

FIG. 5A

CDMA2000 FORWARD LINK, SCH RC4, 1% FER, VERY SLOW POWER CONTROL,
1 PATH RAYLEIGH FADING MODEL, CENTER FREQUENCY = 2 GHz Îor/(No + Ioc) = dB

FIG. 6

FIG. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 00212234 A
- US 4901307 A
- US 5103459 A
- US 96338697 A